# EUROPEAN PATENT SPECIFICATION

(11) **EP 3 174 081 B1**
(45) Date of publication and mention of the grant of the patent: **18.04.2018**
(21) Application number: 16179622.2
(22) Date of filing: 15.07.2016
(51) Int. Cl.: H01H 23/30

(54) **A ROTARY SWITCH**
DREHSCHALTER
COMMUTATEUR ROTATIF

(30) Priority: 25.11.2015 TR 201514960 U
(43) Date of publication of application: 31.05.2017
(73) Proprietor: MAKERSAN MAKINA OTOMOTIV SANAYI TICARET ANONIM SIRKETI, Gebze / Kocaeli (TR)
(72) Inventor: ERKOCAK, Levent, 41490 Kocaeli (TR); ATAY, Asli, 41490 Kocaeli (TR)
(74) Representative: Sevinç, Erkan

(56) References cited:
- EP-A1- 2 282 250
- WO-A1-2010/006762
- FR-A1- 2 823 368
- JP-A- 2013 033 674

## Description

### Technical Field of the Invention

The present invention relates to a switch suitable for multipurpose use, and more particularly it relates to a rotary switch with improved safety which can operate more sensitively and can be controlled by finger.

### State of the Art

Switches, which are suitable for multipurpose use and have a rotary adjusting wheel also referred to as finger joystick, are used as pieces providing precise control especially in the industry and motor vehicle industry. In this type of switches providing non-contact operation, the adjusting wheel touched by the user either rotates by being supported through the whole body or rotates by being supported to a shaft connected to a completely rotating magnetic member. These switches configured appropriately to operate within a limited rotation angle can be easily used by the user with an adjusting wheel disposed thereon.

The patent document No. EP 2297760 B1 can be given as an example to the state of the art. The printed circuit board provided in the rotary switch presented in this patent document is placed in a manner to be positioned horizontally to the bottom surface. In addition, a hollow cylindrical magnetic member is used, which in turn increases the cost. One of the greatest problems encountered in this type of switches is that since the printed circuit board, which is positioned in a longitudinally horizontal manner to the bottom, elongates the general size of the rotary switch, it creates problems in narrow mounting areas. Besides, production of said spring structure is difficult and does not allow for performing gradual force change. Moreover, cost of the hollow cylindrical magnetic member is high and also it is difficult to be magnetized.

Likewise, another patent document No. US 2011/0032058 can be given as an example to the state of the art; in this patent document again, use of a hollow cylindrical magnetic member is mentioned, but the printed circuit board is positioned vertically, when is use, inside the body. Said printed circuit board is placed very close to the lateral walls inside the body and thus, it is in a very close position to the external effects.

Hall effect sensor on the printed circuit board reacts according to the rotation of the magnetic field, and it interacts in an inversely proportional manner to the square of the magnetic field distance. Again, due to the use of a hollow magnetic member, a member the cost of which is increased and which is difficult to be magnetized is used. Moreover, using a single spring creates vulnerability in terms of security in this type of switches. For example, in case a spring becomes nonfunctional, the rotary switch may operate involuntarily. For this reason, use of more than one spring is needed for safety reasons.

Besides, it is aimed to position the adjusting wheel of the rotary switches in the middle position in a void-free manner, but it may be difficult to perform this during mass production. Moreover, to be supported from a single body or shaft requires the use of more parts and complicates obtaining a more compact structure. Accordingly, a rotary switch structure is needed which is more compact and takes a smaller space and also is more cost-effective and the security features of which are increased.

### Objects of the Invention

The main object of the present invention is to obtain a rotary switch structure with improved safety in which fewer parts are used as well as more cost-effective magnetic members are used and which allows for precise control.

Another object of the present invention is to obtain a compact rotary switch will take a smaller space such that it can be used in narrower areas.

Another object of the present invention is to obtain a rotary switch more protected against potential external effects in which the magnetic field is disposed right in the middle of the system in the most proper and effective way.

Another object of the present invention is to obtain a rotary switch in which safety and sensitivity are improved with the use of multiple springs as resilient members.

Another object of the present invention is to obtain a rotary switch structure which allows for gradual progression as a result of the use of multiple shaft members.

Another object of the present invention is to obtain a rotary switch which allows for the use of standard magnetic members and has a magnetic member having low cost and easier to be magnetized.

Another object of the present invention is to obtain a rotary switch in which the magnetic member therein has a protected housing as a result of being embedded inside the shaft and is put under protection against external factors such as vibration.

Yet another object of the present invention is to obtain a rotary switch in which the adjusting wheel is aimed to be positioned in the middle in a void-free manner.

### Summary of the invention

The present invention relates to a switch suitable for multipurpose use, and more particularly it relates to a rotary switch with improved safety. Said switch comprises a main body in which a printed circuit board is placed; an upper body placed on this main body in a manner to partially cover; an adjusting wheel for performing a limited circular motion in a clockwise or counter clockwise direction around an axis; a holding member, when in use, for being kept and controlled by the user on the adjusting wheel; a magnetic member interacts with the printed circuit board in a magnetic and non-contact manner. Said switch further comprises a first shaft and a second shaft which are connected with at least one resilient member and placed mutually on said main body; and support members in the form of a protrusion which allows for the connection with the adjusting wheel on this first shaft and second shaft and that said magnetic member is embedded inside the first shaft and the second shaft.

### Brief Description of the Figures

Accompanying drawings are given solely for the purpose of exemplifying a rotary switch whose advantages over prior art were outlined above and will be explained in detail hereinafter:
Fig. 1 demonstrates an exploded perspective view of the rotary switch according to the present invention.
Fig. 2 demonstrates a cross sectional view of the fig. 1.
Fig. 3 demonstrates a perspective front and rear view of the first shaft according to the present invention.
Fig. 4 demonstrates a perspective view of another shaft according to the present invention.
Fig. 5 demonstrates a cross sectional view of the rotary switch taken along longitudinal axis according to the present invention.
Fig. 6 demonstrates a side perspective view of the rotary switch.

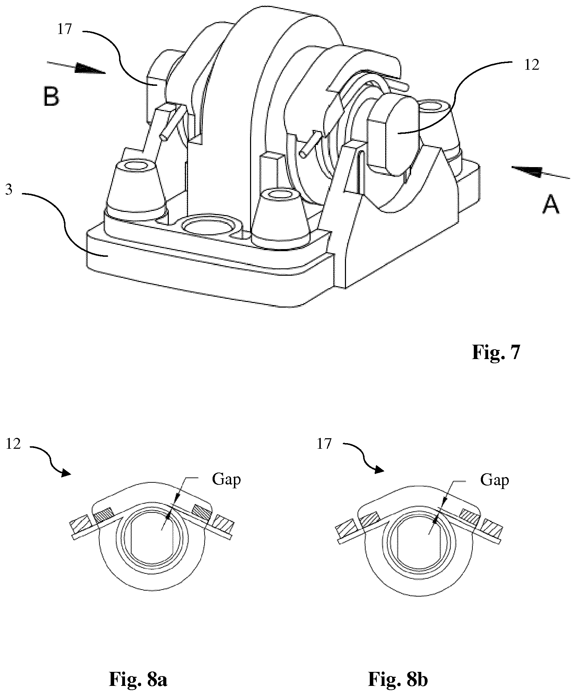

Fig. 7 demonstrates a perspective view of the rotary switch where the adjusting wheel is removed according to the present invention.
Fig. 8a demonstrates a cross sectional view of the first shaft taken from the "A" view of the fig. 7.
Fig. 8b demonstrates a cross sectional view of the first shaft taken from the "B" view of the fig. 7.
Fig. 9 demonstrates a power-motion graphic of the rotary switch according to the present invention.

### Detailed Description of the Invention

In this part, the invention will be described in detail with reference to the figures given in the annex of the description. The reference list used in the figures is herein below:
- 1.: Printed circuit board
- 2.: Sensor
- 3.: Main body
- 4.: PCB housing
- 5.: Main body first shaft housing
- 6.: Main body second shaft housing
- 7.: Upper body
- 8.: Recess
- 9.: First shaft recess
- 10.: Second shaft recess
- 11.: Resilient member support
- 12.: First shaft
- 15.: Shaft protrusion
- 16.: Support member
- 17.: Second shaft
- 19: Bearing
- 21.: Resilient member
- 22.: Adjusting wheel
- 24.: Holding member
- 30.: Adjusting wheel protrusion
- 31.: Adjusting wheel spring
- 32.: Magnetic member
- 40.: Switch
- 41.: First shaft housing
- 42.: Second shaft housing
- 43.: First shaft resilient member housing
- 44.: Second shaft resilient member housing
- 45.: Abutment portion

Referring now to the figures outlined above, the switch (40) presented according to the present invention comprises an adjusting wheel (22) connected with the holding member (24), a first shaft (12) and a second shaft (17) to be connected with the adjusting wheel (22), main body (3) having a bottom in the form of rectangular prism, an upper body (7) positioned on said main body (3), a printed circuit board (1) and at least one resilient member (21) to be positioned inside the main body (3).

The switch (40) presented within the scope of the invention has an adjusting wheel (22) which can also be referred to as a rotary switch or joystick suitable to be controlled by finger and can be easily moved by the user finger, wherein it allows for switching suitable for use in the industry and motor vehicles. It comprises an adjusting wheel (22) suitable for performing circular rotation on a fixed main body (3) in a limited angle direction and first shaft (12) and second shaft (17) in a manner to correspond to the housings disposed on this adjusting wheel (22). A magnetic member (32) is disposed inside one of said shafts, preferably inside the first shaft (12). Moreover, said first shaft (12) can preferably be embedded inside the body along with a bearing (19) in the form of a hollow ring. The bearing (19) preferably made of brass allowing for more precise embedding can be used along with the second shaft (17), but there is not any obligation of the use thereof within the scope of the invention.

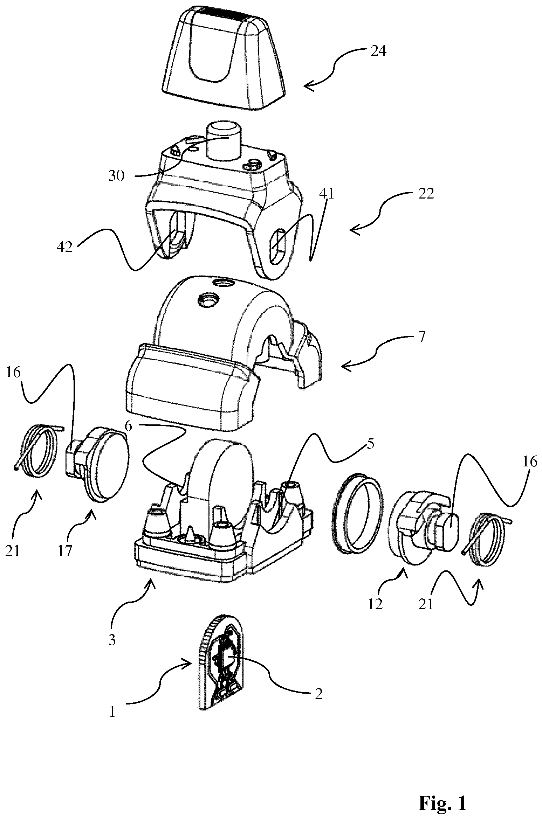

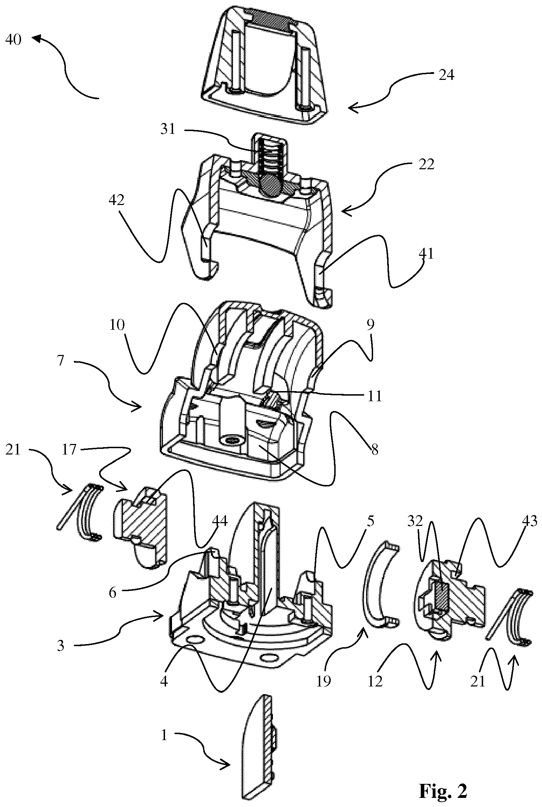

Referring to Figure 1, a sensor is disposed on the printed circuit board (1) suitable for use as printed circuit board (PCB), wherein this sensor (2) is preferably used as a hall effect sensor. Said printed circuit board (1), as can be seen in Figure 2, is positioned inside the PCB housing (4) which extends vertically from the bottom of the main body (3) and is in a protrusion preferably close to the middle section thereof. Thus, it is aimed to obtain a safe switch with the printed circuit board (1) placed close to the middle section of the switch (40) to be further from external effects. Preferably semicircular main body shaft housings are disposed near both long edges of the main body (3). These shaft housings formed semi-circularly are formed as main body second shaft housing (6) and main body first shaft housing (5), respectively on the main body in a manner to fit on the first shaft (12) and the second shaft (17) as will be seen in Figure 2.

Referring to Figure 2, the hollowed recess (8) section of the upper body (7) is formed in a manner to grip the main body (3).

The upper body positioned on the shafts, which are placed on the main body (3), by gripping the same comprises a first shaft recess (9) and second shaft recess (10) having an inclined surface according to the first shaft (12) and the second shaft (17), respectively. Referring to Figure 2, each shaft structure is used along with springs as resilient members (21). A housing is disposed on each shaft for positioning of the resilient member thereon. For example, as will be seen in Figure 2, a first shaft resilient member housing (43) extending circularly on the first shaft (12) is disposed; likewise, a second shaft resilient member housing (44) extending circularly on the second shaft (17) is disposed. Moreover, support members as resilient member support (11) are disposed again on the inner wall of the upper body (7) for the assembly of the resilient members.

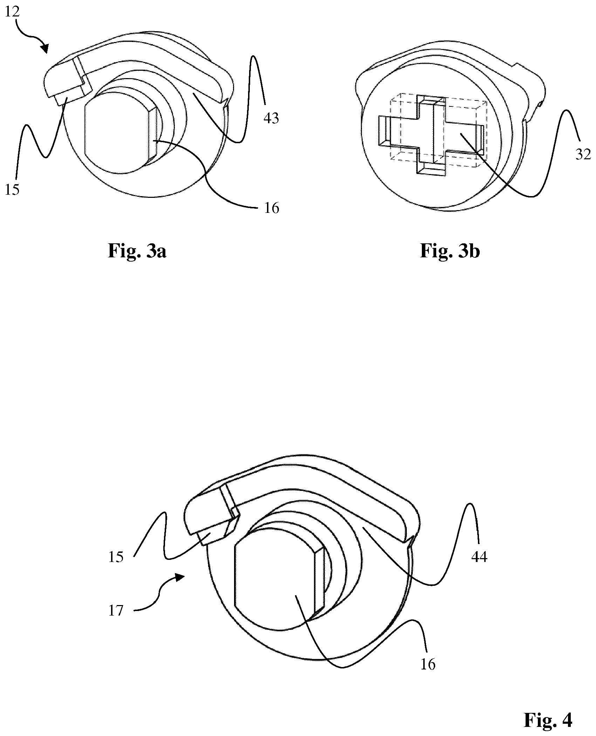

Front and rear perspective view of the first shaft (12) presented within the scope of the invention is given in Figures 3a and 3b. Embedded view of the magnetic member (32) inside said first shaft (12) is shown in Figure 3b. Referring to Figure 3a, a shaft protrusion (15) is disposed in a manner to facilitate the assembly of the resilient member (21) placed in the resilient member housing (43). Likewise, the second shaft (17) also comprises a shaft protrusion (15). These shaft protrusions are positioned especially to prevent the resilient member (21) from going out of the region it is present. As also can be seen in Figures 3a and 4, each shaft structure comprises a flat-edged support member (16). As said resilient member, preferably double arm torsion spring is used. Using each shaft along with the torsion spring both increases safety and allows for precise control.

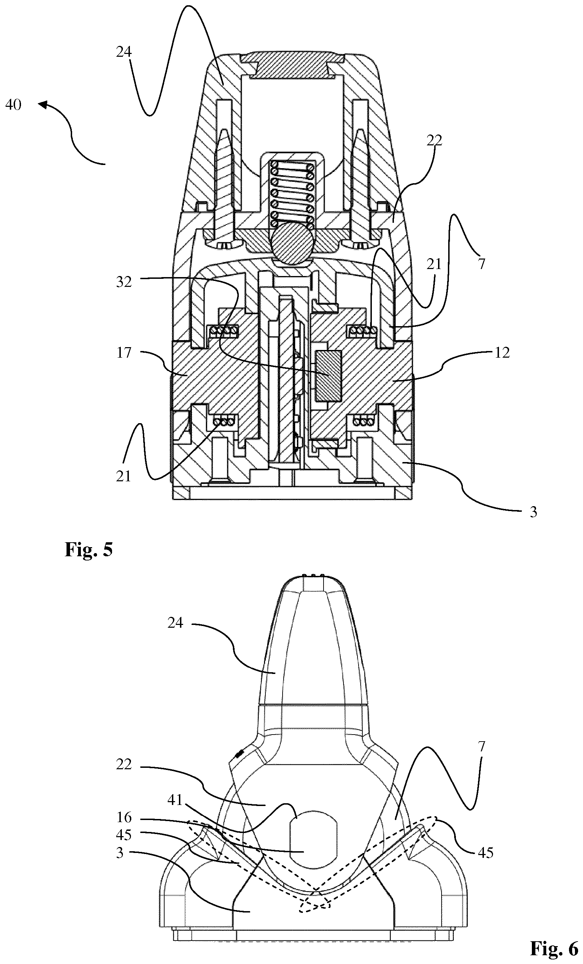

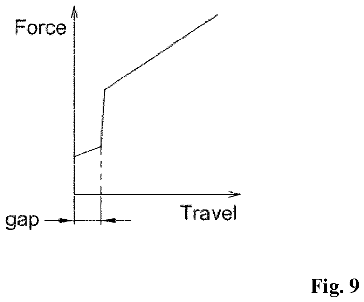

A housing is disposed on the arms, which extend downward, of the adjusting wheel (22) placed on the upper body (7) in a manner to be connected with each shaft. Referring to Figure 1, the first shaft housing (41) disposed on one arm of the adjusting wheel (22) is connected with the support member (16) disposed on the first shaft (12) and extending outward in the form of a protrusion. Similarly, this time the second shaft housing (42) disposed on an opposite arm of the adjusting wheel (22) is connected with the protrusion-shaped support member (16) of the second shaft (17). The important point here is that said first shaft housing (41) and second shaft housing (42) are shaped and sized according to the support member (16) disposed on said first shaft (12) and second shaft (17). The view of this connection is shown in Figure 6. Thus, supporting of the adjusting wheel with said shafts and clockwise and counter clockwise rotation thereof in a single axis direction are provided. Again, the rotation axis of the adjusting wheel (22) is limited with the protrusions disposed on the adjusting wheel (22). Referring to the power-motion graphic in the Figure 9, motion graph occurring as a result of the motion of adjusting wheel (22) is presented and it is seen that initially the resilient members (21) are not in a complete interaction. One of the internally shaded areas of the shafts comprises at least partially space compared to the shaded areas of the upper body. Thus, during the use, while one arm of one of the resilient members (21) is exposed to tension, right arm of the other resilient member (21) is exposed to tension and the adjusting wheel (22) is allowed to remain in the middle in a void-free manner. As will be seen in Figure 9, when more power starts to be applied to the adjusting wheel (22), after progressing as much as the space in the middle, arms of both resilient members interact with each other and act together. In brief, during the first use, while left or right arm of said resilient member (21) is stressed, left or right arm of the other resilient member (21) is stressed in a reverse manner.

Holding member (24) which provides the user to hold the switch (40) in a manner to rotate it is connected to the adjusting wheel (22) with the cylindrical adjusting wheel protrusion (30) the inner surface of which is hollowed and which is disposed preferably on two connection members and adjusting wheel. Adjusting wheel (22) comprises an adjusting wheel spring (31), wherein this spring is pressed by means of a pin.

As magnetic member can be disposed preferably inside one of the shafts in the switch (40) presented within the scope of the invention, it is also possible that magnetic member (32) is disposed inside each shaft. While vertical positioning of the printed circuit board (1) on the body (3) provides advantage in terms of space, use of more than one spring and support of the adjusting wheel with two shafts increases both sensitivity and safety.

It is possible to keep the printed circuit board (1) inside the main body (3) with suitable claws and to fill the housing it is present with epoxy as the filling material for complete sealing. Preferably four connection housings are disposed in the end sections of the main body (3). As can be seen in Figure 6, a V-shaped abutment portion (45), the middle of which is rounded, is disposed on the main body (3) and lateral surface of the upper body (7). The maximum position to be taken by the adjusting wheel (22) is limited with this abutment portion (45).

It is one of the aim to obtain a switch (40) which is more resistant to possible shocks with the magnetic member (32) embedded preferably inside the first shaft (12), and on the other hand, the use of common and more cost-effective magnetic members is provided with the removal of the hollow magnetic member (32). Although a hall effect sensor suitable for operation in a magnetic and non-contact manner is used as a sensor on the printed circuit board (1), it is also possible to use similar type of magnetic field sensors or reed switch.

## Claims

1. A switch (40) comprising: a main body (3) in which a printed circuit board (1) is placed;
an upper body (7) placed on the main body (3) in a manner to at least partially cover the main body (3); an adjusting wheel (22) for performing a limited circular motion in a clockwise or counter clockwise direction around an axis;
a holding member (24) placed on the adjusting wheel (22) for being kept and controlled by the user;
at least two magnetic members (32) which interact with the printed circuit board (1) in a non-contact manner, **characterized in that**
a first shaft (12) and a second shaft (17) are placed on said main body (3) in a same direction, and each of said first shaft (12) and second shaft (17) is connected with at least one resilient member (21);
a support member (16) is protruded from each of first shaft (12) and second shaft (17) for connection with the adjusting wheel (22), and
said magnetic members (32) are embedded in both first and second shaft (12, 17).

2. The switch (40) as in Claim 1 wherein said switch comprises a PCB housing (4) which extends vertically to the bottom of said main body (3) and thus allows for vertical positioning of the printed circuit board (1).

3. The switch (40) as in Claim 1, wherein said switch comprises a hall effect sensor (2) which allows for a magnetic and non-contact operation on the printed circuit board (1).

4. The switch (40) as in Claim 1, wherein said switch comprises a first shaft resilient member housing (43) which allows a resilient member (21) to be positioned on the first shaft (12).

5. The switch (40) as in Claim 4, wherein said switch comprises a second shaft resilient member housing (44) which allows a resilient member (21) to be positioned on the second shaft (17).

6. The switch (40) as in Claim 1, wherein said switch comprises a shaft protrusion (15) in interaction with the resilient member (21) on the first shaft (12) and a shaft protrusion (15) in interaction with the resilient member (21) on the second shaft (17).

7. The switch (40) as in Claim 1 wherein said switch comprises a first shaft housing (41) and a second shaft housing (42) which are shaped and sized according to the support member (16) disposed in the first shaft (12) and second shaft (17), respectively on said adjusting wheel (22).

8. The switch (40) as in Claim 1, wherein said resilient member (21) is a double arm torsion spring.

9. The switch (40) as in Claim 1, wherein said switch comprises a first shaft recess (9) and a second shaft recess (10) on the upper body (7).

10. The switch (40) as in Claim 1, wherein said switch comprises a semicircular main body first shaft housing (5) and a main body second shaft housing (6) in which first shaft (12) and second shaft (17) are placed on the main body (3).

11. The switch (40) as in Claim 1, wherein arms of said resilient member (21) are configured such that when left or right arm of the resilient member (21) is stressed, in use, other left or right arm of the other resilient member (21) is stressed in a reverse direction.

## Patentansprüche

1. Schalter (40), mit:
einem Hauptkörper (3), in dem eine gedruckte Leiterplatte (1) angeordnet ist,
einem oberen Körper (7), der auf dem Hauptkörper (3) so angeordnet ist, dass er den Hauptkörper (3) zumindest teilweise bedeckt,
einem Einstellrad (22) zum Ausführen einer begrenzten Drehbewegung in einer Uhrzeiger- oder Gegenuhrzeigerrichtung um eine Achse,
einem auf dem Einstellrad (22) angeordneten Haltebauteil (24) zum Halten und Steuern durch den Benutzer,
mindestens zwei magnetischen Elementen (32), die auf kontaktlose Weise mit der gedruckten Leiterplatte (1) zusammenwirken, **dadurch gekennzeichnet, dass**
eine erste Welle (12) und eine zweite Welle (17) auf dem Hauptkörper (3) in einer gleichen Richtung angeordnet sind, wobei jede der ersten Welle (12) und der zweiten Welle (17) mit wenigstens einem federnden Bauteil (21) verbunden ist,
ein Stützbauteil (16) von jeder der ersten Welle (12) und der zweiten Welle (17) zur Verbindung mit dem Einstellrad (22) hervorragt, und
die magnetischen Elemente (32) in den beiden ersten und zweiten Wellen (12, 17) eingebettet sind.

2. Schalter (40) nach Anspruch 1, bei dem der Schalter ein Leiterplattengehäuse (4) aufweist, welches sich vertikal zum Boden des Hauptkörpers (3) erstreckt und somit eine vertikale Anordnung der gedruckten Leiterplatte (1) erlaubt.

3. Schalter (40) nach Anspruch 1, bei dem der Schalter einen Hall-Effekt-Sensor (2) aufweist, der einen magnetischen und kontaktlosen Betrieb auf der gedruckten Leiterplatte (1) erlaubt.

4. Schalter (40) nach Anspruch 1, bei dem der Schalter ein Gehäuse (43) für ein federndes Bauteil der ersten Welle aufweist, das es erlaubt, ein federndes Bauteil (21) auf der ersten Welle (12) anzuordnen.

5. Schalter (40) nach Anspruch 4, bei dem der Schalter ein Gehäuse (44) für ein federndes Bauteil der zweiten Welle aufweist, das es erlaubt, ein federndes Bauteil (21) auf der zweiten Welle (17) anzuordnen.

6. Schalter (40) nach Anspruch 1, bei dem der Schalter einen Wellenvorsprung (15) in Wechselwirkung mit dem federnden Bauteil (21) auf der ersten Welle (12) und einen Wellenvorsprung (15) in Wechselwirkung mit dem federnden Bauteil (21) auf der zweiten Welle (17) aufweist.

7. Schalter (40) nach Anspruch 1, wobei der Schalter eine erste Wellenaufnahme (41) und eine zweite Wellenaufnahme (42), die entsprechend dem an der ersten Welle (12) bzw. der zweiten Welle (17) angeordneten Stützbauteil (16) geformt und bemessen sind, an dem Einstellrad (22) aufweist.

8. Schalter (40) nach Anspruch 1, bei dem das federnde Bauteil (21) eine Doppelarm-Torsionsfeder ist.

9. Schalter (40) nach Anspruch 1, bei dem der Schalter eine erste Wellenaussparung (9) und eine zweite Wellenaussparung (10) auf dem oberen Körper (7) aufweist.

10. Schalter (40) nach Anspruch 1, bei dem der Schalter eine halbkreisförmige erste Hauptkörperwellenaufnahme (5) und eine zweite Hauptkörperwellenaufnahme (6) aufweist, in der die erste Welle (12) und die zweite Welle (17) auf dem Hauptkörper (3) angeordnet sind.

11. Schalter (40) nach Anspruch 1, bei dem Arme des federnden Bauteils (21) so ausgestaltet sind, dass dann, wenn ein linker oder rechter Arm des federnden Bauteils (21) im Gebrauch gespannt ist, der andere linke oder rechte Arm des anderen federnden Bauteils (21) in einer umgekehrten Richtung gespannt ist.

## Revendications

1. Commutateur (40) comprenant : un corps principal (3) dans lequel une carte de circuit imprimé (1) est placée ;
un corps supérieur (7) placé sur le corps principal (3) de façon à recouvrir au moins partiellement le corps principal (3) ;
une roue d'ajustement (22) pour réaliser un mouvement circulaire limité dans le sens horaire ou antihoraire autour d'un axe ;
un élément de maintien (24) placé sur la roue d'ajustement (22) pour être maintenu et commandé par l'utilisateur ;
au moins deux éléments magnétiques (32) qui interagissent sans contact avec la carte de circuit imprimé (1), **caractérisé par le fait que**
un premier arbre (12) et un second arbre (17) sont placés sur ledit corps principal (3) dans une même direction, et chacun desdits premier arbre (12) et second arbre (17) est relié à au moins un élément élastique (21) ;
un élément de support (16) fait saillie à partir de chacun desdits premier arbre (12) et second arbre (17) en vue d'une liaison à la roue d'ajustement (22), et
lesdits éléments magnétiques (32) sont intégrés à la fois dans le premier et le second arbre (12, 17).

2. Commutateur (40) selon la revendication 1, dans lequel ledit commutateur comprend un boîtier de carte de circuit imprimé (4) qui s'étend verticalement vers la partie inférieure dudit corps principal (3) et, de ce fait, permet le positionnement vertical de la carte de circuit imprimé (1).

3. Commutateur (40) selon la revendication 1, dans lequel ledit commutateur comprend un capteur à effet Hall (2) qui permet une action magnétique et sans contact sur la carte de circuit imprimé (1).

4. Commutateur (40) selon la revendication 1, dans lequel ledit commutateur comprend un boîtier d'élément élastique de premier arbre (43) qui permet à un élément élastique (21) d'être positionné sur le premier arbre (12).

5. Commutateur (40) selon la revendication 4, dans lequel ledit commutateur comprend un boîtier d'élément élastique de second arbre (44) qui permet à un élément élastique (21) d'être positionné sur le second arbre (17).

6. Commutateur (40) selon la revendication 1, dans lequel ledit commutateur comprend une saillie d'arbre (15) en interaction avec l'élément élastique (21) sur le premier arbre (12) et une saillie d'arbre (15) en interaction avec l'élément élastique (21) sur le second arbre (17).

7. Commutateur (40) selon la revendication 1, dans lequel ledit commutateur comprend un boîtier de premier arbre (41) et un boîtier de second arbre (42) qui sont formés et dimensionnés en fonction de l'élément de support (16) disposé dans le premier arbre (12) et dans le second arbre (17), respectivement sur ladite roue d'ajustement (22).

8. Commutateur (40) selon la revendication 1, dans lequel ledit élément élastique (21) est un ressort de torsion à deux bras.

9. Commutateur (40) selon la revendication 1, dans lequel ledit commutateur comprend un évidement de premier arbre (9) et un évidement de second arbre (10) sur le corps supérieur (7).

10. Commutateur (40) selon la revendication 1, dans lequel ledit commutateur comprend un boîtier de premier arbre de corps principal semi-circulaire (5) et un boîtier de second arbre de corps principal (6), dans lesquels le premier arbre (12) et le second arbre (17) sont placés sur le corps principal (3).

11. Commutateur (40) selon la revendication 1, dans lequel des bras dudit élément élastique (21) sont configurés de telle sorte que, lorsqu'un bras gauche ou droit de l'élément élastique (21) est contraint, en utilisation, l'autre bras gauche ou droit de l'autre élément élastique (21) est contraint dans une direction inverse.
